# EUROPEAN PATENT APPLICATION

(11) **EP 4 195 255 A1**
(43) Date of publication of application: **14.06.2023**
(21) Application number: 21853449.3
(22) Date of filing: 30.07.2021
(51) Int. Cl.: H01L 23/28, H01L 23/29, H01L 23/31, C08K 5/54, C08L 45/00, C08L 101/00, C08L 63/00, C08L 79/00, C08K 3/013, C08K 3/22

(54) **HEAT-CURABLE RESIN COMPOSITION AND SEMICONDUCTOR DEVICE**

(30) Priority: 05.08.2020 JP 2020132827
(71) Applicant: SHIN-ETSU CHEMICAL CO., LTD., Tokyo 1000005 (JP)
(72) Inventor: OSADA, Shoichi, Annaka-shi, Gunma 379-0224 (JP); KAWAMURA, Norifumi, Annaka-shi, Gunma 379-0224 (JP); HORIGOME, Hiroki, Annaka-shi, Gunma 379-0224 (JP); HAGIWARA, Kenji, Annaka-shi, Gunma 379-0224 (JP); YOKOTA, Ryuhei, Annaka-shi, Gunma 379-0224 (JP)
(74) Representative: Sonnenhauser, Thomas Martin
(86) International application number: PCT/JP2021/028227
(87) International publication number: WO 2022/030370

(57) **Abstract**

The present invention is a thermosetting resin composition, including: (A) a thermosetting resin; (B) a laser direct structuring additive; (C) an inorganic filler; and (D) a coupling agent, wherein (D) the coupling agent contains one or more selected from the group consisting of a triazine functional group-, isocyanate functional group-, isocyanuric acid functional group-, benzotriazole functional group-, acid anhydride functional group-, azasilacyclopentane functional group-, imidazole functional group-, and unsaturated group-containing-silane coupling agent, and is not a mercaptosilane coupling agent, an amino silane coupling agent, or an epoxy silane coupling agent. This provides a thermosetting resin composition that gives a cured material on a surface of which a plating layer is formed without the plating layer peeling away from the cured material, and the cured material generates no cracks.

## Description

### TECHNICAL FIELD

The present invention relates to: a thermosetting resin composition which gives a cured material and is able to fabricate a coating layer or a wiring layer on a cured material surface, a cured material cross section, and an opening portion by electroless plating or the like; a cured material of the thermosetting resin composition; and a semiconductor device having the cured material.

### BACKGROUND ART

In semiconductor devices mounted in communication equipment such as mobile phones and smartphones, it is necessary to impart electromagnetic shielding property in order to prevent malfunction due to electromagnetic noise generated by the equipment.

Methods for imparting electromagnetic shielding property to semiconductor devices include methods by sheet metal processing, methods of depositing a metal layer on a semiconductor surface by sputtering, etc. However, methods of imparting electromagnetic shielding property by sheet metal processing are not suitable for thinning and miniaturization of communication equipment. Meanwhile, methods for depositing a metal layer by sputtering require high vacuum in the process, so that continuous production is impossible, and productivity is degraded.

In addition, with development in wearable devices or the like, semiconductor device are also required to be even thinner. Accordingly, a metal wiring pattern is formed on a surface of a semiconductor sealing material by plating to make it possible to form a new semiconductor device directly on a semiconductor device.

Miniaturization of semiconductor devices for communication equipment is also being attempted by forming an antenna on the surface of a semiconductor sealing material besides wiring.

As a part of such development, technology is developing in recent years for connecting multiple chips with high-density wiring by providing a rewiring layer outside the chips in chip size package with wafer level sealing. However, copper electroplating, etc. are mainstream as processes used in current rewiring, and the process is extremely complicated, including application of a resist, pattern formation, washing, sputtering, removal of the resist, and electroplating. Meanwhile, in methods by electroplating, resins and chips are also required to have chemical resistance.

In this situation, a technique called laser direct structuring (hereinafter, referred to as "LDS") is developing as a method for selectively constructing a plating pattern (Patent Document 1). In this technique, an LDS additive is added to thermoplastic resin, and a cured material thereof is activated with a laser, so that a plating layer (metal layer) can be formed on just the irradiated portions. This technique has a characteristic that a metal layer can be formed on a surface, cross section, or opening of a cured material without using an adhesive layer, resist, etc. (Patent Documents 2 and 3).

In addition, thermosetting resin compositions for LDS excellent in plating property and three-dimensionally molded circuit components using the compositions are also developing with an LDS additive added not only in thermoplastic resin, but also in thermosetting resin (Patent Document 4).

However, problems also occur that the metal wiring after plating peels off from the cured material, and that cracks appear in the cured material. This is considered to arise from the bond between the LDS additive to be a nucleus for the deposition of the plating metal and the thermosetting resin being weak, and the bond between the deposited plating metal and the thermosetting resin being weak. If the bond is insufficient, a gap of the order of micron occurs at the interface between the LDS additive and the thermosetting resin and at the interface between the deposited plating metal and the thermosetting resin in an LDS activation step by laser-irradiation and alkaline electroless plating step. This makes the metal layer after plating liable to be delaminated from the cured material. It is also considered that a cause is cracks occurring, starting from the gap when mechanical stress or thermal stress is applied to the cured material.

### CITATION LIST

### PATENT LITERATURE

Patent Document 1: JP 2004-534408 A
Patent Document 2: JP 2015-108123 A
Patent Document 3: WO 2015/033295 A1
Patent Document 4: JP 6265308 B1

### SUMMARY OF INVENTION

### TECHNICAL PROBLEM

The present invention has been made to solve the above-described problems, and an object thereof is to provide a thermosetting resin composition that gives a cured material on a surface, cross section, or opening of which a plating layer is formed without the plating layer peeling away from the cured material, and the cured material generates no cracks.

### SOLUTION TO PROBLEM

To solve the problems, the present invention provides
a thermosetting resin composition, comprising:
(A) a thermosetting resin;
(B) a laser direct structuring additive;
(C) an inorganic filler; and
(D) a coupling agent,
wherein (D) the coupling agent contains one or more selected from the group consisting of a triazine functional group silane coupling agent, an isocyanate functional group silane coupling agent, an isocyanuric acid functional group silane coupling agent, a benzotriazole functional group silane coupling agent, an acid anhydride functional group silane coupling agent, an azasilacyclopentane functional group silane coupling agent, an imidazole functional group silane coupling agent, and an unsaturated group-containing silane coupling agent, and (D) the coupling agent is not a mercaptosilane coupling agent, an amino silane coupling agent, or an epoxy silane coupling agent.

With the inventive thermosetting resin composition, a plating layer formed on a surface, cross section, or opening of a cured material of the composition does not peel away from the cured material, and cracks do not occur in the cured material either.

Furthermore, in the present invention, the component (B) is preferably a metallic oxide which is represented by an average composition formula of the following formula (1) and which has a spinel structure,

AB₂O₄ (1)

wherein "A" is one or more metallic elements selected from the group consisting of iron, copper, nickel, cobalt, zinc, magnesium, and manganese and B is iron, chromium, or tungsten, wherein "A" and B are not both iron at the same time.

When such a component (B) is added to a thermoplastic resin composition as an LDS additive, a plating layer (metal layer) can be formed efficiently only on irradiated portions by activating a cured material of the composition with a laser or the like.

Furthermore, in the present invention, a hexavalent chromium content in the component (B) is preferably less than 100 ppm.

A thermosetting resin composition containing such a component (B) conforms to the directive of the European Union (EU) regarding the restriction of the use of certain hazardous substances in electrical and electronic equipment (RoHS Directive), and waste electric and electronic equipment can be recycled easily.

Furthermore, in the present invention, the component (B) is preferably a laser direct structuring additive that is not surface-treated.

Such a component (B) is not liable to cause delamination of a plating layer and degradation of mechanical strength, since the component (B) is not surface-treated.

Furthermore, in the present invention, (A) the thermosetting resin preferably contains one or more selected from (i) epoxy resin, (ii) a cyclic imide compound containing, in one molecule thereof, one or more dimer acid skeletons, one or more linear alkylene groups having 6 or more carbon atoms, and two or more cyclic imide groups, (iii) a cyanate ester compound having two or more cyanato groups in one molecule thereof, and (iv) a cyclopentadiene compound represented by the following formula (2) and/or an oligomer thereof, 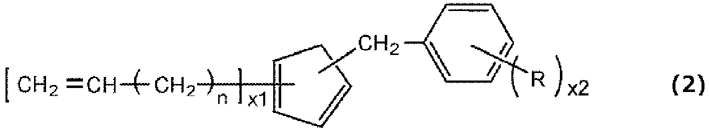 wherein in the formula (2), R represents a group selected from an alkyl group having 1 to 6 carbon atoms, an alkenyl group having 2 to 6 carbon atoms, and an aryl group having 6 to 10 carbon atoms, "n" is an integer of 1 to 4, and x1 and x2 are independently 0, 1, or 2, wherein when R represents an alkyl group or an aryl group, x1 is 1 or 2, and 1 ≤ x1 + x2 ≤ 4.

Such a resin can be used suitably as the component (A) .

Furthermore, the present invention provides a cured material of the above-described thermosetting resin composition.

A plating layer formed on a surface, cross section, or opening of such a cured material does not become peeled from the cured material, and cracks do not occur in the cured material either. Therefore, such a cured material is useful as communication devices that require electromagnetic shielding property, antennas, and a sealing material for semiconductor devices provided with a wiring layer or the like.

Furthermore, the present invention provides a semiconductor device, having the above-described cured material.

The inventive semiconductor device has the cured material. Thus, this is excellent in adhesiveness of a metal layer of antennas, wiring layers, etc. In addition, continuous production is possible so that the semiconductor device is excellent in productivity.

In this case, a part or all of the cured material is preferably plated.

In such a semiconductor device, a metal layer is formed on a surface, cross section, or opening of the cured material selectively and efficiently without using an adhesive layer or a resist, etc. In addition, there is no peeling of the plating or cracks occurring in the cured material, and therefore, such a semiconductor device is highly reliable.

Moreover, the present invention provides a method for manufacturing the above-described semiconductor device, comprising:
plating a part or all of the cured material,
wherein the plating is performed on a laser-irradiated portion.

According to such a method for manufacturing a semiconductor device, continuous production may be performed more effectively, and therefore, such a method is excellent in productivity.

### ADVANTAGEOUS EFFECTS OF INVENTION

The inventive thermosetting resin composition is a composition that gives a cured material having a strong bond at the interface between an LDS additive and a thermosetting resin and at the interface between a deposited plating metal and a thermosetting resin. A metal layer (plating layer, etc.) can be formed selectively and easily on a surface or inside of the cured material of the composition by electroless plating and/or the like. This metal layer (plating layer, etc.) has a strong bond with the cured material, and is not detached easily. In addition, cracks due to mechanical stress or thermal stress do not occur. Accordingly, the inventive thermosetting resin composition is suitable as a sealing material for compact and thin communication devices that require electromagnetic shielding property, semiconductor devices equipped with an antenna, and semiconductor devices provided with a wiring layer, etc. In addition, a semiconductor device having a cured material of the inventive composition can be continuously produced, and is excellent in productivity.

### DESCRIPTION OF EMBODIMENTS

As described above, it has been desired to develop a thermosetting resin composition that gives a cured material with a strong bond at the interfaces between an LDS additive and a thermosetting resin and between a formed metal layer and the thermosetting resin.

To solve the above problems, the present inventors have earnestly studied and found out that including a silane coupling agent with a particular structure in a thermosetting resin composition containing an LDS additive enables the bond at the interface between the LDS additive and the thermosetting resin to become stronger, and completed the present invention.

That is, the present invention provides the following thermosetting resin composition, a cured material of the composition, and a semiconductor device having the cured material.

Hereinafter, the present invention will be described in detail, but the present invention is not limited thereto.

The inventive thermosetting resin composition is a thermosetting resin composition containing:
(A) a thermosetting resin;
(B) a laser direct structuring additive;
(C) an inorganic filler; and
(D) a coupling agent,
where (D) the coupling agent contains one or more selected from the group consisting of a triazine functional group silane coupling agent, an isocyanate functional group silane coupling agent, an isocyanuric acid functional group silane coupling agent, a benzotriazole functional group silane coupling agent, an acid anhydride functional group silane coupling agent, an azasilacyclopentane functional group silane coupling agent, an imidazole functional group silane coupling agent, and an unsaturated group-containing silane coupling agent, and (D) the coupling agent is not a mercaptosilane coupling agent, an amino silane coupling agent, or an epoxy silane coupling agent. Components other than the components (A) to (D) can be further contained as needs arise.

Hereinafter, each component will be described.

### [(A) Thermosetting Resin]

The inventive thermosetting resin composition contains (A) a thermosetting resin.

The thermosetting resin can be, for example, a resin containing one or more selected from epoxy resin; phenol resin; a cyclic imide compound containing, in one molecule thereof, at least one dimer acid skeleton, at least one linear alkylene group having 6 or more carbon atoms, and at least two cyclic imide groups; a cyanate ester compound having two or more cyanato groups in one molecule thereof; a cyclopentadiene compound and/or an oligomer thereof; oxetane resin; (meth)acrylate resin; terminal (meth)acrylic group-modified polyphenylene ether resin; unsaturated polyester resin; diallyl phthalate resin; maleimide resin; and the like.

In particular, the thermosetting resin preferably contains (i) epoxy resin, (ii) a cyclic imide compound containing, in one molecule thereof, one or more dimer acid skeletons, one or more linear alkylene groups having 6 or more carbon atoms, and two or more cyclic imide groups, (iii) a cyanate ester compound having two or more cyanato groups in one molecule thereof, and (iv) a cyclopentadiene compound and/or an oligomer thereof.

The epoxy resin is not particularly limited, and examples include epoxy resins conventionally used in a technical field of epoxy resin compositions for semiconductor-sealing. Examples of such epoxy resins include crystalline epoxy resins such as phenol novolak epoxy resin, ortho-cresol novolak epoxy resin, naphthol novolak epoxy resin, biphenyl epoxy resin, bisphenol epoxy resin, stilbene epoxy resin, and dihydroanthracenediol epoxy resin; polyfunctional epoxy resins such as triphenolmethane epoxy resin and alkyl-modified triphenolmethane epoxy resin; aralkyl epoxy resins such as phenolaralkyl epoxy resin having a phenylene skeleton, biphenylaralkyl epoxy resin having a biphenylene skeleton, naphtholaralkyl epoxy resin having a phenylene skeleton, and naphtholbiphenylaralkyl epoxy resin having a biphenylene skeleton; naphthol epoxy resins such as dihydroxynaphthalene epoxy resin and epoxy resin obtained by converting a dimer of dihydroxynaphthalene to a glycidyl ether form; triazine nucleus-containing epoxy resins such as triglycidyl isocyanurate and monoallyldiglycidyl isocyanurate; and cyclic hydrocarbon compound-modified phenol epoxy resins such as dicyclopentadiene-modified phenol epoxy resin. One of these may be used, or two or more thereof may be used in combination. In particular, novolak epoxy resins such as ortho-cresol novolak epoxy resin, aralkyl epoxy resins such as biphenylaralkyl epoxy resin, and biphenyl epoxy resin are preferable for suppressing the viscosity of the composition.

A curing agent can be used in combination with the epoxy resin. As the curing agent, phenol resin, acid anhydride, amine, active ester, etc. can be used. In particular, phenol resin is preferable in view of heat resistance and moisture resistance. The phenol resin includes novolak phenol resin, naphthalene ring-containing phenol resin, aralkyl biphenyl resin, aralkyl phenol resin, triphenolalkane phenol resin, biphenyl phenol resin, alicyclic phenol resin, heterocyclic phenol resin, naphthalene ring-containing phenol resin, and bisphenol phenol resins such as bisphenol A phenol resin, and bisphenol F phenol resin. One of these may be used, or two or more thereof may be used in combination. Among these, novolak phenol resin, aralkyl biphenyl resin, aralkyl phenol resin, and biphenylaralkyl phenol resin are preferable, and aralkyl phenol resin is particularly preferable.

The blending ratio of the epoxy resin to the curing agent (epoxy group/phenolic hydroxy group) is preferably 0.5 or more and 1.5 or less by equivalent ratio, more preferably 0.8 or more and 1.2 or less. When the blending ratio is within this range, the curing agent is appropriate and economically advantageous, and curing becomes sufficient.

Examples of a curing accelerator of the epoxy resin and the phenol resin include imidazoles such as 2-methylimidazole, 2-ethyl-4-methylimidazole, 2-methyl-4-ethylimidazole, 2-phenylimidazole, and 2-methyl-4-methylimidazole; tertiary amines such as 1,8-diazabicyclo[5.4.0]undecene-7, triethylenediamine, and benzyldimethylamine; organic phosphines such as triphenylphosphine, tributylphosphine, and tetraphenylphosphonium-tetraphenylborate; microencapsulated materials of these compounds; and compounds having a urea structure such as N,N,N',N'-tetramethyl urea, N'-phenyl-N,N-dimethyl urea, N,N-diethyl urea, N'-[3-[[[(dimethylamino)carbonyl]amino]methyl]-3,5,5-trimethylcyclohexyl]-N,N-dimethyl urea, and N,N"-(4-methyl-1,3-phenylene)bis(N',N'-dimethyl urea). One of these may be used, or two or more thereof may be used in combination.

In particular, N,N-diethyl urea and N'-[3-[[[(dimethylamino)carbonyl]amino]methyl]-3,5,5-trimethylcyclohexyl]-N,N-dimethyl urea are preferable since these have the potential to cause a curing reaction only when a certain temperature has been reached.

The curing accelerator is preferably added in an amount of 0.5 to 10.0 parts by mass, more preferably 1.5 to 6.0 parts by mass relative to 100 parts by mass of the total of the epoxy resin as (A) and the phenol resin component. Within such a range, the epoxy groups and the phenolic hydroxy groups react rapidly, and a cured material can be obtained easily.

The cyclic imide compound is not particularly limited, and examples include a cyclic imide compound containing, in one molecule thereof, one or more dimer acid skeletons, one or more linear alkylene groups having 6 or more carbon atoms, and two or more cyclic imide groups. In addition, a maleimide compound is preferable as the cyclic imide compound, and in particular, a maleimide compound represented by the following general formula (3) is more preferable. Note that the "A" and B in the following formula apply only to this formula. 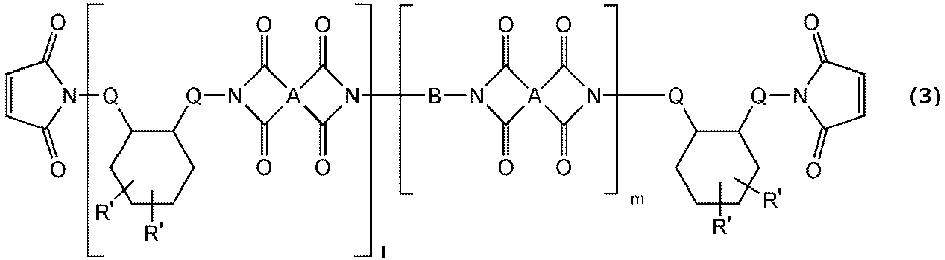 In the general formula (3), "A" independently represents a tetravalent organic group containing an aromatic ring or an aliphatic ring. B is an alkylene group having 6 to 18 carbon atoms and an aliphatic ring optionally containing at least one divalent heteroatom. Q independently represents a linear alkylene group having 6 or more carbon atoms. R' each independently represents a linear or branched alkyl group having 6 or more carbon atoms. "1" represents a number of 1 to 10. "m" represents a number of 0 to 10.

The Q in the general formula (3) is a linear alkylene group, and has 6 or more carbon atoms, and preferably has 6 or more and 20 or fewer, more preferably 7 or more and 15 or fewer.

The R' in the general formula (3) is an alkyl group, and may be a linear alkyl group or a branched alkyl group. The R' has 6 or more carbon atoms, preferably 6 or more and 12 or fewer.

The "A" in the general formula (3) represents a tetravalent organic group containing an aromatic ring or an aliphatic ring, in particular, "A" is preferably one of the tetravalent organic groups represented by the following structural formulae. 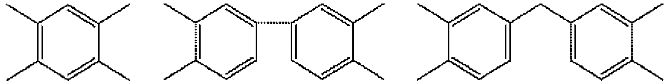 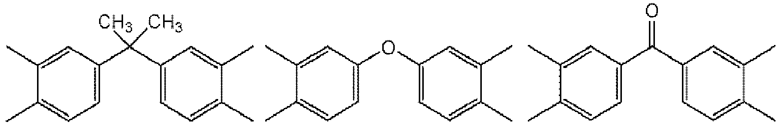 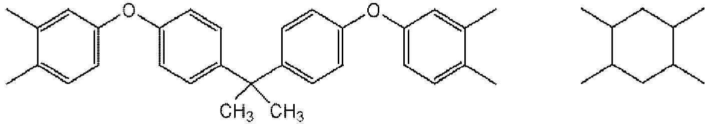 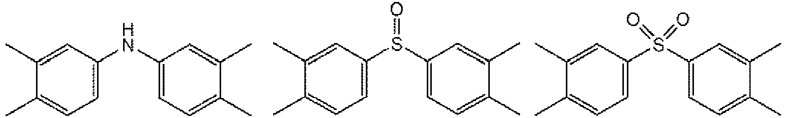 The attachment points without bonding to substituents in the structural formulae each bond to a carbonyl carbon forming a cyclic imide structure in the general formula (3) .

The B in the general formula (3) is an alkylene group having an aliphatic ring optionally containing at least one divalent heteroatom and having 6 to 18 carbon atoms. The alkylene group preferably has 8 or more and 15 or fewer carbon atoms. The B in the general formula (3) is preferably one of the alkylene groups having an aliphatic ring represented by the following structural formulae. 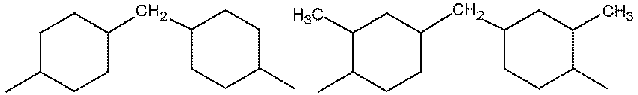 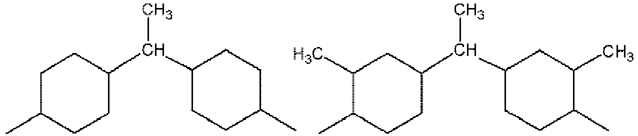 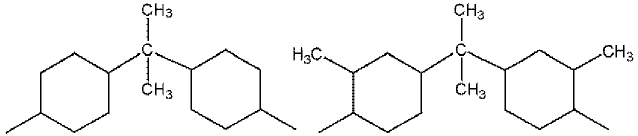 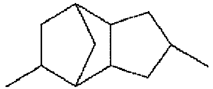 The attachment points without bonding to substituents in the structural formulae each bond to a nitrogen atom forming a cyclic imide structure in the general formula (3) .

"1" in the general formula (3) is a number of 1 to 10, preferably a number of 2 to 7. "m" in the general formula (3) is a number of 0 to 10, preferably 0 to 7.

The weight-average molecular weight (Mw) of the cyclic imide compound is not particularly limited including properties at room temperature (25°C), but a weight-average molecular weight measured by gel permeation chromatography (GPC) in terms of polystyrene is preferably 70,000 or less, more preferably 1,000 or more and 50,000 or less. When the molecular weight is 70,000 or less, there is no risk of the obtained composition becoming too viscous and having lowered flowability, and formability in laminate molding or the like becomes excellent.

Note that the weight-average molecular weight (Mw) referred to in the specification indicates a weight-average molecular weight measured by GPC under the following conditions in terms of polystyrene standard.

### [Measurement Conditions]

Eluent: tetrahydrofuran
Flow rate: 0.35 mL/min
Detector: RI
Column: TSK gel H type (manufactured by Tosoh Corporation)
Column temperature: 40°C
Sample injection amount: 5 µL

The cyclic imide compound may be synthesized by polymerization of a corresponding acid anhydride and a diamine, or may employ a commercially available article such as BMI-1500, BMI-3000, BMI-5000 (all manufactured by Designer Molecules Inc.), SLK-1500, SLK-3000, SLK-2600 (all manufactured by Shin-Etsu Chemical Co., Ltd.), etc. In addition, one kind of cyclic imide compound may be used, or two or more kinds thereof may be used in combination.

A polymerization initiator may be added in the cyclic imide compound as necessary.

Examples of the polymerization initiator include dicumyl peroxide, diisobutyl peroxide, di-t-butyl peroxide, 2,5-dimethyl-2,5-bis (t-butylperoxy) hexane, di(2-t-butylperoxyisopropyl)benzene, and the like. One of these may be used or two or more thereof may be used in combination.

The amount of the polymerization initiator (curing agent) to be added is not particularly limited, but can be 0.2 to 5 parts by mass, preferably 0.5 to 3 parts by mass relative to 100 parts by mass of the component (A).

The cyanate ester compound is not particularly limited. It is sufficient for the cyanate ester compound to have two or more cyanato groups in one molecule thereof, and a generally known cyanate ester compound can be used. The cyanate ester compound can be represented by the following general formula (4), for example. 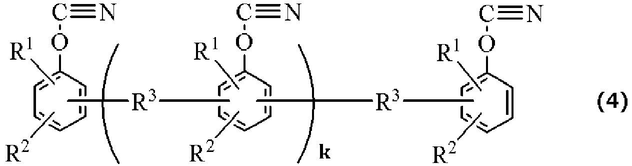 In the formula, R¹ and R² are each independently a hydrogen atom or an alkyl group having 1 to 4 carbon atoms, and R³ is each independently one of the following. 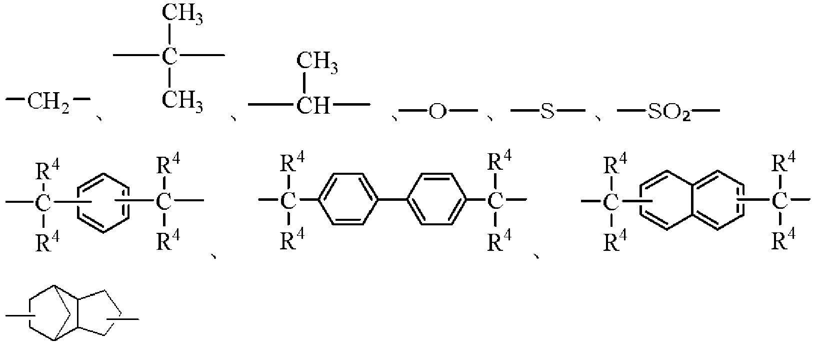 In the formulae, R⁴ is a hydrogen atom or a methyl group. "k" is an integer of 0 to 10.

Examples of the cyanate ester compound include bis(4-cyanatophenyl)methane, bis(3-methyl-4-cyanatophenyl)methane, bis(3-ethyl-4-cyanatophenyl)methane, bis(3,5-dimethyl-4-cyanatophenyl)methane, 1,1-bis(4-cyanatophenyl)ethane, 2,2-bis(4-cyanatophenyl)propane, 2,2-bis(4-cyanatophenyl)-1,1,1,3,3,3-hexafluoropropane, 1,3- and 1,4-dicyanatobenzene, 2-tert-butyl-1,4-dicyanatobenzene, 2,4-dimethyl-1,3-dicyanatobenzene, 2,5-di-tert-butyl-1,4-dicyanatobenzene, tetramethyl-1,4-dicyanatobenzene, 1,3,5-tricyanatobenzene, 2,2'- or 4,4'-dicyanatobiphenyl, 3,3',5,5'-tetramethyl-4,4'-dicyanatobiphenyl, 1,3-, 1,4-, 1,5-, 1,6-, 1,8-, 2,6-, or 2,7-dicyanatonaphthalene, 1,3,6-tricyanatonaphthalene, 1,1,1-tris(4-cyanatophenyl)ethane, bis(4-cyanatophenyl)ether, 4,4'-(1,3-phenylenediisopropylidene)diphenylcyanate, bis(4-cyanatophenyl)thioether, bis(4-cyanatophenyl)sulfone, tris(4-cyanato-phenyl)phosphine, tris(4-cyanatophenyl)phosphate, phenol novolak cyanate, cresol novolak cyanate, dicyclopentadiene novolak cyanate, phenylaralkyl cyanate ester, biphenylaralkyl cyanate ester, and naphthalenearalkyl cyanate ester. One of these cyanate ester compounds may be used or a mixture of two or more thereof may be used.

In addition, a cyanate ester compound with a smaller cyanate group equivalent, that is, with a smaller molecular weight between functional groups causes smaller cure shrinkage, so that a cured material with lower thermal expansion and higher glass-transition temperature (Tg) can be obtained. A cyanate ester compound with a larger cyanate group equivalent has a somewhat lower Tg, but a triazine crosslink interval becomes flexible, so that lower elasticity, higher toughness, and lower water absorption can be expected. The chlorine bonded or remaining in the cyanate ester compound is preferably 50 ppm or less, more preferably 20 ppm or less. When the amount of chlorine is 50 ppm or less, oxidized Cu frames, Cu wires, and/or Ag plating do not become corroded by chlorine or chlorine ions that are separated by pyrolysis when placed under high temperature for a long time, so that delamination or electrical failure of the cured material do not occur, and the insulating property of the resin is not degraded either.

A curing agent can be added to the cyanate ester compound as necessary.

As the curing agent, a phenol resin mentioned above can be used.

The cyclopentadiene compound and/or the oligomer thereof is not particularly limited, and examples of the cyclopentadiene compound include cyclopentadiene compounds represented by the following formula (2). 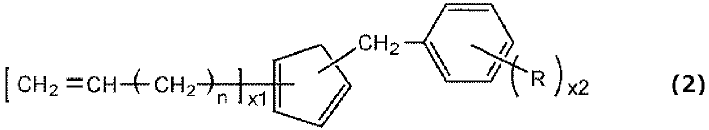 In the formula (2), R represents a group selected from an alkyl group having 1 to 6 carbon atoms, an alkenyl group having 2 to 6 carbon atoms, and an aryl group having 6 to 10 carbon atoms, "n" is an integer of 1 to 4, and x1 and x2 are independently 0, 1, or 2, wherein when R represents an alkyl group or an aryl group, x1 is 1 or 2, and 1 ≤ x1 + x2 ≤ 4.

In the formula (2), "n" is an integer of 1 to 4, preferably 1 to 2, particularly preferably 1. x1 is 0, 1, or 2, preferably 0 or 1. x2 is 0, 1, or 2, preferably 1 or 2.

Meanwhile, R represents a group selected from an alkyl group having 1 to 6 carbon atoms, an alkenyl group having 2 to 6 carbon atoms, and an aryl group having 6 to 10 carbon atoms. Examples of the alkyl group include a methyl group, an ethyl group, a propyl group, an isopropyl group, an n-butyl group, an isobutyl group, a t-butyl group, an n-pentyl group, an isopentyl group, a neopentyl group, a t-pentyl group, an n-hexyl group, an isohexyl group, a cyclopentyl group, and a cyclohexyl group.

Examples of the alkenyl group include a vinyl group, an allyl group, an isopropenyl group, a butenyl group, a pentenyl group, and a hexenyl group.

Furthermore, examples of the aryl group include a phenyl group, a tolyl group, a xylyl group, a mesityl group, a benzyl group, a biphenyl group, and a naphthyl group.

In particular, R is preferably an alkenyl group, and a vinyl group and an allyl group are particularly preferable.

When R represents an alkyl group or an aryl group, x1 is 1 or 2, preferably 1, and 1 ≤ x1 + x2 ≤ 4, preferably 1 ≤ x1 + x2 ≤ 2.

The cyclopentadiene ring of the compound represented by the formula (2) has excellent reactivity. Therefore, the compound represented by the formula (2) easily dimerizes and/or trimerizes by a Diels-Alder reaction to produce a dimer and/or trimer. Incidentally, the reaction of the dimerization and trimerization may be a reaction between cyclopentadiene compounds having the same structure or a reaction between cyclopentadiene compounds having different structures from one another.

The each proportion of dimers and oligomers of the compound represented by the formula (2) is calculated from an area ratio of a peak measured by gel permeation chromatography (GPC).

In addition, an oligomer of the compound represented by the formula (2) preferably has a dicyclopentadiene ring structure.

A reaction in which the cyclopentadiene ring of the compound of the formula (2) reacts to form a dicyclopentadiene ring, i.e., a Diels-Alder reaction between the cyclopentadiene rings in two molecules of the compound of the formula (2), occurs more readily than a reaction between a cyclopentadiene ring and another carbon-carbon double bond that can undergo a Diels-Alder reaction. Therefore, it can be considered that a large amount of the compound having a dicyclopentadiene ring is contained in the component.

As a structure for the oligomer, those in the following formulae can be exemplified. 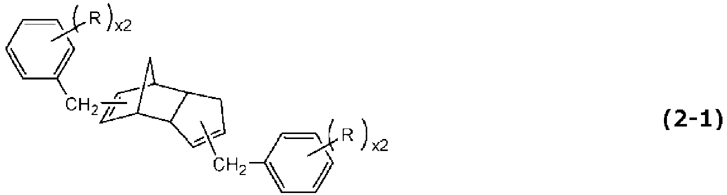 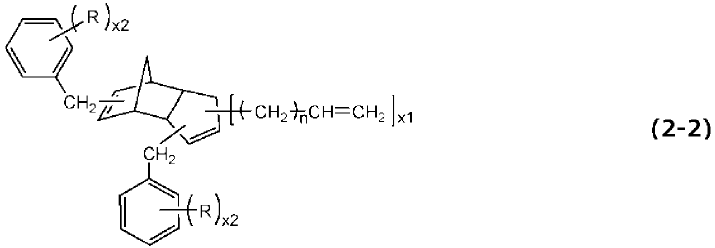 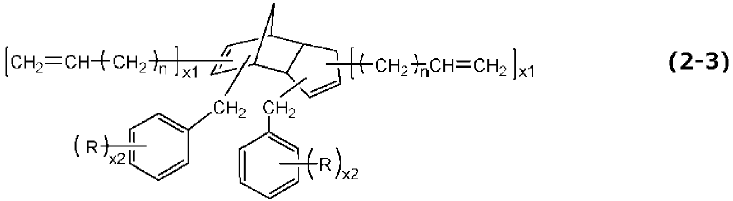 In the formulae, R, n, x1, and x2 are each the same as above. 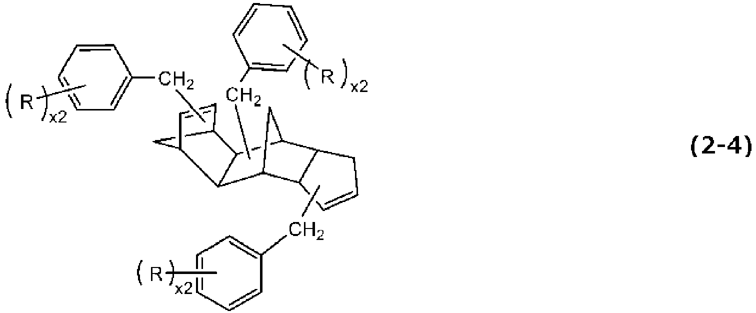 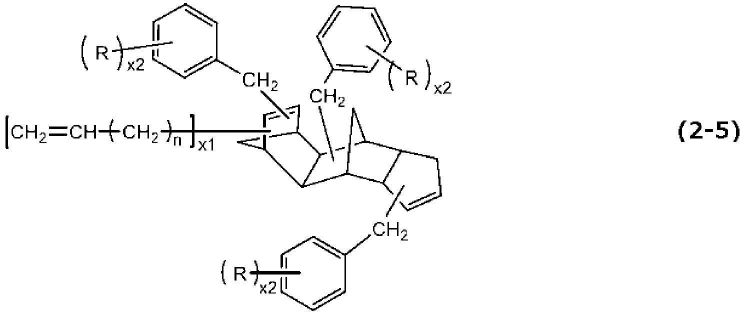 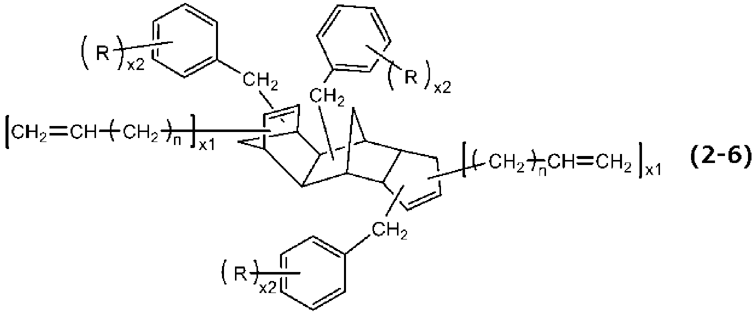 In the formulae, R, n, x1, and x2 are each the same as above. 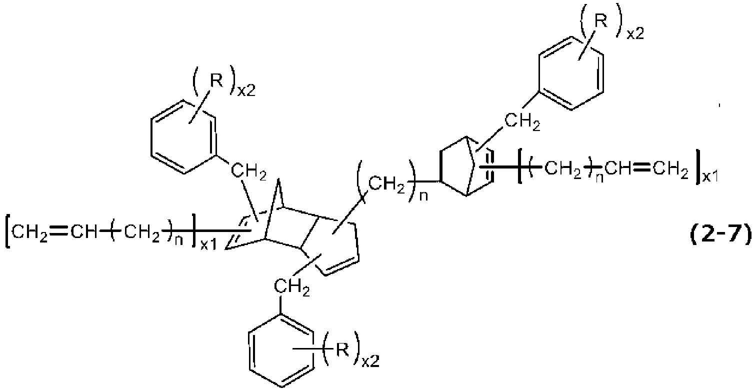 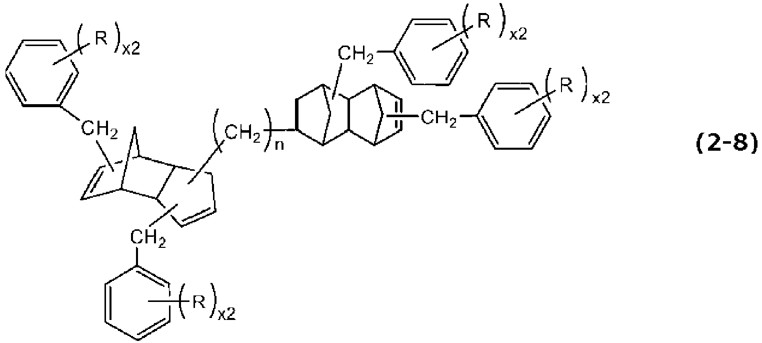 In the formulae, R, n, x1, and x2 are each the same as above.

The above-described oligomer can be obtained by heating the compound represented by the formula (2) at 50 to 200°C, preferably 60 to 180°C, more preferably 70 to 160°C, for 20 minutes to 180 minutes, preferably 40 minutes to 150 minutes, more preferably 60 minutes to 120 minutes. This reaction is preferably performed under vacuum (reduced pressure).

Furthermore, the heating of the compound represented by the formula (2) can be performed without a solvent, and if necessary, can be performed in a high-boiling-point solvent such as toluene, xylene, and anisole.

To achieve 3 mass% or more of dimers of the cyclopentadiene compound represented by the formula (2) in the component, the compound represented by the formula (2) is preferably heated at 70 to 160°C for 1 hour to 2 hours under vacuum.

One kind of the cyclopentadiene compound and/or the oligomer thereof can be used, or two or more kinds thereof can be used in combination.

A polymerization initiator can be added to the cyclopentadiene compound and/or oligomer thereof if necessary.

Examples of the polymerization initiator include dicumyl peroxide, diisobutyl peroxide, di-t-butyl peroxide, 2,5-dimethyl-2,5-bis(t-butyl peroxy)hexane, and di(2-t-butylperoxyisopropyl)benzene. One of these may be used or two or more thereof may be used in combination.

The amount of the polymerization initiator (curing agent) to be added is not particularly limited, but can be 0.2 to 5 parts by mass, preferably 0.5 to 3 parts by mass relative to 100 parts by mass of the component (A).

### (B) Laser Direct Structuring Additive (LDS Additive)

(B) a laser direct structuring additive (LDS additive) is added to the thermosetting resin, and makes it possible to form a plating layer (metal layer) only on irradiated portions by activating a cured material thereof by the use of an activation energy beam such as a laser. It is considered that when an LDS additive is irradiated with an activation energy beam such as a YAG laser having a wavelength range that is absorbable in it, metal nuclei become activated (reduced, for example), so that metal nuclei that make metal plating possible are produced. In addition, when a surface of a cured material of the thermosetting resin composition having an LDS additive dispersed is irradiated with the activation energy beam, a seed region having metal nuclei that make metal plating possible is formed on the irradiated surface. By using the obtained seed region, it becomes possible to form a plating pattern such as a circuit on the surface of the cured material of the thermosetting resin composition.

(B) the LDS additive is not particularly limited as long as metal nuclei can be formed by irradiation with an activation energy beam, and those disclosed in Patent Documents 2 to 4 can be used, for example. The LDS additive is preferably a metallic oxide which is represented by an average composition formula of the following formula (1) and which has a spinel structure.

AB₂O₄ (1)

In the formula, "A" is one or more metallic elements selected from iron, copper, nickel, cobalt, zinc, magnesium, and manganese and B is a metallic element iron, chromium, or tungsten, where "A" and B are not both iron at the same time.

Specific examples include FeCr₂O₄, CuCr₂O₄, NiCr₂O₄, CoCr₂O₄, ZnCr₂O₄, MgCr₂O₄, MnCr₂O₄, CuFe₂O₄, NiFe₂O₄, CoFe₂O₄, ZnFe₂O₄, MgFe₂O₄, MnFe₂O₄, and CuW₂O₄.

Methods for manufacturing these metallic oxides of LDS additives are not limited, and it is possible to use a metallic oxide manufactured by calcining a mixed powder of a metallic oxide, oxidizing a mixture of a metallic powder, chemical synthesis, etc.

The shape of the LDS additive is preferably of fine particles, and the average particle size (median size (D50)) thereof is preferably 0.01 to 5 um, and particularly preferably falls within the range of 0.05 to 3.0 um in a measured value of volume particle size distribution measured by a laser diffraction particle size distribution analyzer. When the LDS additive has an average particle size of 0.01 to 5 um, the LDS additive is distributed uniformly across the entire resin, and this promotes the generation of a metal seed that is to be a plating catalyst when irradiating a package surface with a laser. Thus, plating property is improved.

The LDS additive is preferably blended in an amount of 20 to 100 parts by mass, more preferably 30 to 80 parts by mass relative to 100 parts by mass of the component (A). When the amount is 20 parts by mass or more, the generation of the metal nuclei that are to be a plating catalyst when irradiating with a laser becomes sufficient, so that plating property becomes favorable. When the amount is 100 parts by mass or less, there is no risk of portions other than the laser-irradiated portions being plated. In addition, the proportion of metallic oxide particles with a small particle size becomes appropriate, and the flowability and molding property of the composition become favorable.

In the world of electric and electronic equipment, there is a strong worldwide trend towards green purchasing and green design in recent years, and safer materials are desired. For example, in Europe, the directive of the European Union (EU) regarding the restriction of the use of certain hazardous substances in electrical and electronic equipment (RoHS Directive) is put into operation. Accordingly, when the B in the above-described AB₂O₄ is chromium, in particular, the amount of hexavalent chromium contained is preferably less than 900 ppm, further preferably less than 100 ppm so as to conform to the RoHS Directive and make the recycling of waste electric and electronic equipment easier, and in addition, so as not to affect humans or the environment when finally disposed by landfill or burning. The lower limit of the hexavalent chromium content is preferably as small as possible, so the lower limit is not particularly limited, but 0 ppm can be exemplified. A method for analyzing hexavalent chromium is as follows.

### <Hexavalent Chromium Analysis Method>

20 g of sodium hydroxide and 30 g of sodium carbonate are dissolved in ion-exchanged water to prepare 1 liter of an aqueous alkaline solution. The pH is to be 11.5 or higher.

2.5 g of an LDS additive is weighed and placed in a clean container, and 1 mL of a 40% aqueous magnesium chloride solution, 1 M of a phosphate buffer, and 50 mL of an aqueous alkaline solution are added. The mixture is stirred for 5 to 10 minutes.

The resultant is shaken in a water bath of 90 to 95°C for 1 hour, and left to stand at room temperature for 20 to 40 minutes.

12 mL or more of the solution is drawn into a 30-mL syringe, and filtered with a 0.45-um filter. The filtrate is placed in a 50-mL disposable beaker.

10 mL of the filtered extract is measured with a pipette, and is placed in a 50-mL measuring flask. After adding 1.5 to 2.0 mL of concentrated nitric acid thereto, an ion-exchanged water is added so that the mixture is 50 mL.

The prepared liquid is measured with fluorescent X-rays, and is quantified using a calibration curve of hexavalent chromium prepared in advance.

There is a grade of LDS additive that is surface-treated with an inorganic material for enhancing dispersibility. However, using a surface-treated additive sometimes leads to delamination of a plating layer and degradation of mechanical strength.
Therefore, a grade that is not surface-treated is desirable.

### (C) Inorganic Filler

(C) an inorganic filler includes a material such as fused silica, crystalline silica, cristobalite, alumina, silicon nitride, aluminum nitride, boron nitride, titanium oxide, glass fiber, alumina fiber, zinc oxide, talc, and calcium carbide, while excluding the above-described component (B). Two or more of these may be used in combination. The top cut size of (C) the inorganic filler is preferably 5 to 25 um, more preferably 10 to 20 um in a wet sieve method. The average particle size D50 of (C) the inorganic filler is preferably 1 to 10 um, more preferably 3 to 7 um in a measured value of volume particle size distribution measured by a laser diffraction particle size distribution analyzer.

The top cut size referred to here indicates the size of openings of the sieve used in the classification of the manufactured inorganic filler by the wet sieve method, and refers to a value at which the proportion of particles that are larger than the size of the said openings becomes 2 volume% or less in a measured value of volume particle size distribution measured by a laser diffraction method. When the top cut size is 25 um or smaller, this does not cause any problems such as a portion on an inorganic filler surface exposed when irradiated with a laser or the like not being plated, or the bond between a plated metal layer and an inorganic filler being insufficient so that the plating becomes liable to delamination. Thus, there is no risk of hindering the formation of a wiring layer or a via.

(C) the inorganic filler is preferably added in an amount of 50 to 1,500 parts by mass, more preferably 150 to 1,200 parts by mass relative to 100 parts by mass of the component (A).

### (D) Coupling Agent

The coupling agent of the component (D) contains one or more selected from the group consisting of a triazine functional group silane coupling agent, an isocyanate functional group silane coupling agent, an isocyanuric acid functional group silane coupling agent, a benzotriazole functional group silane coupling agent, an acid anhydride functional group silane coupling agent, an azasilacyclopentane functional group silane coupling agent, an imidazole functional group silane coupling agent, and an unsaturated group-containing silane coupling agent, and (D) the coupling agent is not a mercaptosilane coupling agent, an amino silane coupling agent, or an epoxy silane coupling agent.

Coupling agents having these functional groups easily coordinates with a metal atom contained in an LDS additive such as copper or with a metal ion in a plating solution to be deposited, and crosslinks with a thermosetting resin. Therefore, such a coupling agent is useful for making the bond between the LDS additive and the thermosetting resin strong. In addition, an alkoxy group bonded to a silicon atom can undergo a condensation reaction and/or form a hydrogen bond with an inorganic filler, and thus, the alkoxy group can also be bonded to a surface of the inorganic filler. Accordingly, a plating metal layer has a strong bond with a cured material, and is not easily detached. In addition, cracks due to mechanical stress and thermal stress do not occur.

Note that the isocyanate functional groups in the isocyanate functional group silane coupling agent may be protected (so-called blocked isocyanate groups) or not protected. Meanwhile, examples of the unsaturated groups in the unsaturated group-containing silane coupling agent include alkenyl groups such as a vinyl group and an allyl group, a styryl group, a (meth)acrylic group, and a (meth)acryloxy group.

Examples of (D) the coupling agent are shown below, but the coupling agent is not limited thereto.

Examples include N-[3-(trimethoxysilyl)propyl]-[1,3,5]triazine-2,4,6-triamine, N-[3-(triethoxysilyl)propyl]-[1,3,5]triazine-2,4,6-triamine, (1-{2-[4,6-diamino-(1,3,5)triazine-2-yl]-ethyl}-3-[3-(trimethoxysilyl)propyl]urea, 1-{2-[4,6-diamino-(1,3,5)triazine-2-yl]-ethyl}-3-[3-(triethoxysilyl)propyl]urea, 3-isocyanatepropyltriethoxysilane, 3-ureidopropyltriethoxysilane, tris-(trimethoxysilylpropyl)isocyanurate, tris-(triethylsilylpropyl)isocyanurate, 1-(3-(trimethoxysilyl)propyl)-3,5-di-2-propenyl-1,3,5-triazine-2,4,6(1H,3H,5H)-trione, 1,3,5-tris(3-(trimethoxysilyl)propyl)1,3,5-triazine-2,4,6(1H,3H,5H)-trione, N-[5-(trimethoxysilyl)-2-aza-1-oxopentyl]caprolactam, N-[5-(triethoxysilyl)-2-aza-1-oxopentyl]caprolactam, N-[3-(triethoxysilyl)propyl]-carbamic acid ethyl ester, N-[3-(trimethoxysilyl)propyl]-carbamic acid ethyl ester, 3,5-dimethyl-N-[3-(trimethoxysilyl)propyl]-1H-pyrazole-1-carboxyamide, 3,5-dimethyl-N-[3-(triethoxysilyl)propyl]-1H-pyrazole-1-carboxyamide, 2-[3-(trimethoxysilyl)propyl]succinic anhydride, 2-[3-(triethoxysilyl)propyl]succinic anhydride, N-(trimethoxysilyl-propyl)-1H-benzotriazole-1-carbodiamide, dihydro-3-(trimethoxysilyl-propyl)-2, 5-furandione, 2, 2-dimethoxy-1-phenyl-1-aza-2-silacyclopentane, N-2-pyridinyl-N-(triethoxysilyl-propyl)-urea, 3-[(trimethoxysilyl)propyl]-1H-imidazole, 3-methacryloxypropyltrimethoxysilane, 3-methacryloxypropyltriethoxysilane, 3-methacryloxypropylmethyldimethoxysilane, 3-methacryloxypropylmethyldiethoxysilane, 3-acryloxypropyltrimethoxysilane, 3-acryloxypropyltriethoxysilane, p-styryltrimethoxysilane, vinyltrimethoxysilane, and vinyltriethoxysilane.

In particular, a silane coupling agent of the following are preferable: N-[3-triethoxysilyl)propyl]-[1,3,5]triazine-2,4,6-triamine, 3-isocyanatepropyltriethoxysilane, 1-(3-(trimethoxysilyl)propyl)3,5-di-2-propenyl-1,3,5-triazine-2,4,6(1H,3H,5H)-trione, N-[5-(trimethoxysilyl)-2-aza-1-oxopentyl]caprolactam, 2-[3-(trimethoxysilyl)propyl]succinic anhydride, N-(trimethoxysilyl-propyl)-1H-benzotriazole-1-carbodiamide, 2, 2-dimethoxy-1-phenyl-1-aza-2-silacyclopentane, and 3-[(trimethoxysilyl)propyl]-1H-imidazole.

One of these may be used or two or more thereof may be used in combination. In addition, a part of the coupling agent may be mixed with the inorganic component (C) beforehand to treat a surface of the inorganic filler in advance.

The amount of the component (D) to be added can be 0.3 parts by mass or more, for example, 0.5 to 8.0 parts by mass relative to 100 parts by mass of the component (A). The amount is preferably 1.0 to 6.0 parts by mass, and further preferably 1.5 to 5.0 parts by mass. When the added amount is 0.3 parts by mass or more, the formation of a bond with the metal in the LDS additive or the metal ions in the plating solution becomes sufficient. When the amount is 8.0 parts by mass or less, the amount of alcohol generated from alkoxy groups is not large, and therefore, frequent occurrence of voids and degradation of electric characteristics, etc. do not occur.

### · Other additives

The inventive resin composition may further contain a release agent, a flame retardant, an ion-trapping agent, a flexibilizer, a colorant, and other additives as necessary.

Examples of the release agent include wax such as carnauba wax, rice wax, polyethylene, polyethylene oxide, montanoic acid, ester compounds of montanoic acid with saturated alcohol, 2-(2-hydroxyethylamino)-ethanol, ethyleneglycol, glycerin, etc.; stearic acid, stearate ester, stearamide, ethylenebisstearamide, a copolymer of ethylene and vinyl acetate. One of these may be used or two or more thereof may be used in combination.

Examples of the flame retardant include halogenated epoxy resin, phosphazene compounds, silicone compounds, zinc molybdate supported with talc, zinc molybdate supported with zinc oxide, aluminum hydroxide, magnesium hydroxide, molybdenum oxide, and antimony trioxide. One of these flame retardants may be used or two or more may be used in combination. In view of environmental load and ensuring flowability, phosphazene compounds, zinc molybdate supported with zinc oxide, and molybdenum oxide are suitably used.

Examples of the ion-trapping agent include hydrotalcite compounds, bismuth compounds, and zirconium compounds, and one of these may be used or two or more thereof may be used in combination.

Examples of the flexibilizer include silicone compounds such as silicone oil, silicone resin, silicone-modified epoxy resin, and silicone-modified phenol resin; and thermoplastic elastomers such as styrene resin, and acrylic resin. One of these may be used or two or more thereof may be used in combination.

Examples of the colorant include carbon black, titanium black, and titanium oxide, and one of these may be used, or two or more thereof may be used in combination.

The amount of these other additives to be contained in the resin composition can be appropriately determined within ranges in which the function of each additive can be favorably exhibited. The amount is, for example, 0.1 parts by mass or more and 20 parts by mass or less relative to 100 parts by mass of the component (A).

### · Method for manufacturing thermosetting resin composition

The inventive thermosetting resin composition is manufactured as follows, for example. That is, a thermosetting resin, an LDS additive, an inorganic filler, a coupling agent, and other materials are each blended in predetermined amounts, and mixed with a mixer or the like to be sufficiently homogeneous. Then, melt mixing treatment is performed with a heat roll, a kneader, an extruder, or the like followed by cooling to solidify and grinding the mixture into appropriate size. The obtained composition can be used as molding material. Furthermore, the material can also be compressed into tablets and used in tablet form.

All or some of the inorganic filler and the coupling agent can also be mixed in advance.

### · Uses for thermosetting resin composition

The inventive thermosetting resin composition is effective as a sealing resin of a semiconductor device of a transistor, module, DIP, SO, flat-pack, ball grid array, chip size package, wafer level package, fan-out package, etc. Methods for sealing a semiconductor device with the inventive thermosetting resin composition are not particularly limited, and conventional molding methods such as transfer molding, injection molding, compression molding, and cast molding, for example, can be employed.

### · Cured material of thermosetting resin composition

The molding (curing) conditions of the inventive thermosetting resin composition are not particularly limited, but are preferably at 120 to 190°C for 90 to 300 seconds. Furthermore, post-curing is preferably performed at 170 to 250°C for 2 to 16 hours.

A metal layer can be provided on a surface of or inside a cured material of the inventive thermosetting resin composition easily and selectively by electroless plating using laser direct structuring. Therefore, the cured material can be used suitably for devices such as communication devices that require electromagnetic shielding property, devices that require antenna circuits, and devices that have a circuit in a sealing resin layer instead of an organic substrate.

### · Semiconductor device

The inventive semiconductor device has a cured material of the inventive thermosetting resin composition, and a part or all of the cured material is preferably plated. Methods for plating the cured material are not particularly limited, but an example is given below.

A surface of the cured material is irradiated with a laser beam with a wavelength selected from 185 nm, 248 nm, 254 nm, 308 nm, 355 nm, 532 nm, 1,064 nm, or 10,600 nm, for example, to achieve a desired wiring and depth. The depth from the surface is 0 to 30 um, preferably 0 to 20 um.

When plating a cut surface of the cured material and an opening of the cured material, the surface or opening is irradiated with a laser beam with a wavelength selected from 185 nm, 248 nm, 254 nm, 308 nm, 355 nm, 532 nm, 1,064 nm, or 10,600 nm in the same manner to achieve a desired depth and hole diameter. Examples include a method of immersing in a plating solution containing a target metal component such as Cu, Ni, and Ag after laser-irradiation. The output power of the laser is preferably 0.01 to 15 W, and the scanning speed of the laser is preferably 1 to 1,000 mm/s. The plating solution can be a solution that contains a complexing agent, a pH adjuster, conducting salt, reducing agent, or the like besides the target metal component, and a generally commercially available solution can be used. The temperature of the plating solution can be 50 to 80°C, and the immersion time can be 20 to 120 minutes.

In such a semiconductor device of the present invention, a metal layer is formed on a surface, cross section, or opening of the cured material selectively and efficiently without using an additional material such as an adhesive layer or a resist. In addition, there is no peeling of the plating or cracks occurring in the cured material, and therefore, such a semiconductor device is highly reliable.

### · Method for manufacturing semiconductor device

The inventive semiconductor device can be manufactured by a known LDS technique by using the inventive thermosetting resin composition. As the LDS technique, those disclosed in Patent Documents 2 to 4 or JP 6423418 B can be adopted, for example.

The semiconductor device having a part or all of the cured material plated can be manufactured by a manufacturing method including plating a part or all of the cured material, where the plating is performed on a laser-irradiated portion. The plating can be performed as described above.

Such a method for manufacturing a semiconductor device is excellent in productivity since continuous production can be performed more effectively.

### EXAMPLE

Hereinafter, the present invention will be described in more detail with reference to Examples and Comparative Examples. However, the present invention is not limited to the following Examples.

The materials used in the Examples and Comparative Examples are shown below. Incidentally, the hexavalent chromium content, average particle size, and top cut size are values determined by the above-described methods.

### (A) Thermosetting resin

· Epoxy resin 1: ortho-cresol novolak epoxy resin: "Epiclon N655EXP-S" manufactured by DIC CORPORATION (epoxy equivalent: 210)
· Epoxy resin 2: biphenylaralkyl epoxy resin: "NC-3000" manufactured by NIPPON KAYAKU Co., Ltd. (epoxy equivalent: 273)
· Cyclic imide compound: bismaleimide resin: "SLK-3000" manufactured by Shin-Etsu Chemical Co., Ltd.
· Cyanate ester compound: novolak cyanate ester compound: "Primaset PT-60" manufactured by Lonza
· Cyclopentadiene compound: "SLK-250" manufactured by Shin-Etsu Chemical Co., Ltd.

In addition, the following components were added as necessary.
· Phenol resin 1: novolak phenol resin: "TD-2093Y" manufactured by DIC CORPORATION (phenol equivalent: 110)
· Phenol resin 2: aralkyl phenol resin: "MEHC-7851SS" manufactured by MEIWA PLASTIC INDUSTRIES, LTD. (phenol equivalent: 175)
· Curing accelerator: N'-[3-[[[(dimethylamino)carbonyl]amino]methyl]-3,5,5-trimethylcyclohexyl]-N,N-dimethyl urea: "U-cat 3513N" manufactured by San-Apro Ltd.
· Polymerization initiator: dicumyl peroxide: "Percumyl D" manufactured by NOF Corporation

### (B) LDS additive

· LDS additive 1: [LD38S: (CuCr₂O₄: hexavalent chromium content: 88 ppm), average particle size: 1.0 um, not surface-treated] manufactured by Shepherd Color Japan, Inc.
· LDS additive 2: [EX-1815: (CuW₂O₄: hexavalent chromium content: less than 10 ppm), average particle size: 0.7 um, not surface-treated] manufactured by Shepherd Color Japan, Inc.
· LDS additive 3: [Black 30C965: (CuCr₂O₄: hexavalent chromium content: 263 ppm), average particle size: 0.9 um, surface-treated] manufactured by Shepherd Color Japan, Inc.

### (C) Inorganic filler

· Silica particles 1: "MUF-4" manufactured by Tatsumori Ltd. (average particle size: 4 um, top cut size: 10 um)
· Alumina particles 1: "AC9104-SXE" manufactured by ADMATECHS (average particle size: 4 um, top cut size: 10 um)

### (D) Coupling agent

· Triazine functional group silane coupling agent: N-[3-triethoxysilyl)propyl]-[1,3,5]triazine-2,4,6-triamine; "VD-5" manufactured by Shikoku Chemicals Corporation
· Isocyanate functional group silane coupling agent: 3-isocyanatepropyltriethoxysilane: [KBE9007N] manufactured by Shin-Etsu Chemical Co., Ltd.
· Isocyanuric acid functional group silane coupling agent: 1-(3-(trimethoxysilyl)propyl)3,5-di-2-propenyl-1,3,5-triazine-2,4,6(1H,3H,5H)-trione: [X-12-1290] manufactured by Shin-Etsu Chemical Co., Ltd.
· Benzotriazole functional group silane coupling agent: N-(trimethoxysilyl-propyl)-1H-benzotriazole-1-carbodiamide: [X-12-1214A] manufactured by Shin-Etsu Chemical Co., Ltd.
· Acid anhydride functional group silane coupling agent: 2-[3-(trimethoxysilyl)propyl]succinic anhydride: [X-12-167C] manufactured by Shin-Etsu Chemical Co., Ltd.
· Azasilacyclopentane functional group silane coupling agent: 2, 2-dimethoxy-1-phenyl-1-aza-2-silacyclopentane: [X-88-398] manufactured by Shin-Etsu Chemical Co., Ltd.
· Imidazole functional group silane coupling agent: 3-[(trimethoxysilyl)propyl]-1H-imidazole: [IS-1000 manufactured by JX Nippon Mining & Metals Corporation]
· Mercapto functional group silane coupling agent: 3-mercaptopropyltrimethoxysilane [KBM-803 manufactured by Shin-Etsu Chemical Co., Ltd.]
· Amino functional group silane coupling agent: N-phenyl-3-aminopropyltrimethoxysilane [KBM-573 manufactured by Shin-Etsu Chemical Co., Ltd.]
· Epoxy functional group silane coupling agent: 3-glycidoxypropyltrimethoxysilane [KBM-403 manufactured by Shin-Etsu Chemical Co., Ltd.]
· Unsaturated group-containing silane coupling agent: p-vinylphenyltrimethoxysilane [KBM-1403 manufactured by Shin-Etsu Chemical Co., Ltd.]

### [Release Agent]

· Polyethylene wax: "Licowax PE 520" manufactured by Clariant Corporation

### [Colorant]

· Acetylene black: "Denka Black" manufactured by Denka Company Limited

### [Examples 1 to 12, Comparative Examples 1 to 8]

The above-described components were blended according to the composition (parts by mass) shown in Tables 1 and 2. In Examples 1 to 10 and Comparative Examples 1 to 7, the components were melt-mixed, cooled, and pulverized to obtain a composition. In Examples 11 and 12 and Comparative Example 8, the components were mixed with a THINKY MIXER, then kneaded with a 3-roll mill to obtain a viscous liquid. Each composition was evaluated according to the method shown below, and the results are shown in Tables 1 and 2.

### [Evaluation of Plating Property of Cured Material]

### (Evaluation of Surface Plating Property)

A 32 mm × 32 mm glass epoxy printed circuit board with a thickness of 1.6 mm having a 10 mm × 10 mm silicon chip with a thickness of 0.75 mm mounted was prepared.

Regarding Examples 1 to 10 and Comparative Examples 1 to 7, molding was performed under transfer conditions of 175°C, 6.9 N/mm², and a cure time of 2 minutes. Subsequently, post-curing was performed at 175°C for 2 hours to fabricate a semiconductor device whose thermosetting resin has a molding size of 28mm × 28 mm and a molding thickness of 1.2 mm.

Regarding Examples 11 and 12 and Comparative Example 8, casting was performed in a simulation semiconductor device with a 28 mm × 28 mm Teflon (registered trademark) frame mounted thereon, and under a nitrogen atmosphere, the temperature was raised to 300°C at a heating rate of 1°C/minute to fabricate a semiconductor device whose thermosetting resin has a size of 28mm × 28 mm and a thickness of 1.2 mm.

Using a YVO₄ laser marker (manufactured by KEYENCE Corporation, 1064 nm), 10 lines with a line width of 50 um and a length of 10 mm were marked on a surface of the cured material at 1-mm intervals at a speed of 1,000 mm/s and an output power of 13 W. The semiconductor device was immersed for 20 minutes in an electroless Cu plating solution of MID Copper 100XB (manufactured by MacDermid, Inc.) heated at 65°C while stirring. After washing with water and drying, the resistance between both ends of the plating wiring having a line width of 50 um and a length of 10 mm formed on the surface of the cured material was measured, and the average of the 10 wirings was recorded.

It was also observed whether portions other than the laser-irradiated portion were plated, and whether there was a short circuit between the wirings.

### (Evaluation of Adhesiveness between Plating Layer and Cured Material)

A peel test was carried out on the surface of the cured material with the plating wiring by using a 3M Scotch Tape (manufactured by 3M Japan Limited). Counting the number of wirings that totally or partially adhered to the peeled Scotch Tape (the plating came off), the number out of the 10 plating wirings was recorded.

### (Temperature Cycle Test)

A temperature cycle test of the semiconductor devices was conducted. The set conditions were: lowest temperature of -40°C/30 minutes; and highest temperature of 150°C/30 minutes. After 1,000 cycles, it was visually observed whether a crack had appeared in the semiconductor device.

### (Evaluation of Internal Plating Property)

Using a laser substrate cutting machine MicroLine 5820P (manufactured by LPKF), ten 200-µmφ through-holes were formed in a 0.20-mm thick cured material.

This formed material was immersed in the above-described plating solution at 65°C for 30 minutes to plate the through-holes. The internal plating property was observed by polishing a cross section of the through-holes, and observing the plating property with a microscope.

**[Table 1]**

| | | Examples | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| (A) | Epoxy resin 1 | 65.0 | 65.0 | 65.0 | 65.0 | | | | | | | | |
| | Epoxy resin 2 | | | | | 60.0 | 60.0 | 60.0 | | | | | |
| | Cyclic imide compound | | | | | | | | 100.0 | 100.0 | | | |
| | Cyanate ester compound | | | | | | | | | | 80.0 | | |
| | Cyclopentadiene compound | | | | | | | | | | | 100.0 | 100.0 |
| | Phenol resin 1 | 35.0 | 35.0 | 35.0 | 35.0 | | | | | | | | |
| | Phenol resin 2 | | | | | 40.0 | 40.0 | 40.0 | | | 20.0 | | |
| | Curing accelerator | 2.0 | | | | | | | | | | | |
| | Polymerization initiator | | | | | | | | 2.0 | 2.0 | | 1.0 | 1.0 |
| (B) | LDS additive 1 | 20.0 | 100.0 | 50.0 | | 70.0 | | | 25.0 | 25.0 | 50.0 | 20.0 | 20.0 |
| | LDS additive 2 | | | | | | 70.0 | 70.0 | | | | | |
| | LDS additive 3 | | | | 50.0 | | | | | | | | |
| (C) | Silica particles 1 | 200.0 | | 600.0 | 600.0 | 650.0 | 650.0 | 650.0 | 250.0 | 250.0 | 500.0 | 180.0 | 180.0 |
| | Alumina particles 1 | | 1000.0 | | | | | | | | | | |
| (D) | Triazine functional group silane coupling agent | | 2.0 | | | | | | | | | | |
| | Isocyanate functional group silane coupling agent | | | 2.0 | 2.0 | | | | | | 2.0 | | |
| | Isocyanuric acid functional group silane coupling agent | | | | | | | | | 1.0 | | 2.0 | |
| | Benzotriazole functional group silane coupling agent | | | | | 2.0 | | | | | | | |
| | Acid anhydride functional group silane coupling agent | | | | | | 2.0 | 3.3 | 1.0 | | | | |
| | Azasilacyclopentan e functional group silane coupling agent | 3.4 | 5.0 | 3.0 | 3.0 | 3.3 | 3.3 | | 1.3 | 1.3 | 2.5 | 0.9 | |
| | Imidazole functional group silane coupling agent | | | | | | | 1.0 | | | | | |
| | Unsaturated group-containing silane coupling agent | | | | | | | | | | | | 2.0 |
| | Release agent | 1.0 | 1.0 | 1.0 | 1.0 | 1.0 | 1.0 | 1.0 | 1.0 | 1.0 | 1.0 | 1.0 | 1.0 |
| | Colorant | 0. 5 | 0. 5 | 0. 5 | | 0. 5 | | | 0. 5 | 0. 5 | 0. 5 | 0. 5 | 0. 5 |
| Evaluat ion results | Hexavalent chromium content in LDS additive (ppm) | 88 | 88 | 88 | 263 | 88 | <10 | <10 | 88 | 88 | 88 | 88 | 88 |
| | Plating wiring resistance (Ω) | <1 | <1 | <1 | <1 | <1 | <1 | <1 | <1 | <1 | <1 | <1 | <1 |
| | Presence or absence of short circuit between wirings | Absent | Absent | Absent | Absent | Absent | Absent | Absent | Absent | Absent | Absent | Absent | Absent |
| | Adhesiveness evaluation (number of peeled platings (out of 10)) | 0 | 0 | 0 | 0 | 0 | 0 | 0 | 0 | 0 | 0 | 0 | 0 |
| | Temperature cycle test (presence or absence of cracks) | Absent | Absent | Absent | Absent | Absent | Absent | Absent | Absent | Absent | Absent | Absent | Absent |
| | Internal plating property | Excell ent | Excelle nt | Excell ent | Excell ent | Excell ent | Excell ent | Excell ent | Excell ent | Excell ent | Excell ent | Excell ent | Excell ent |

**[Table 2]**

| | | Comparative Examples | | | | | | | |
|---|---|---|---|---|---|---|---|---|---|
| | | 1 | 2 | 3 | 4 | 5 | 6 | 7 | 8 |
| (A) | Epoxy resin 1 | 65.0 | 65.0 | 65.0 | 65.0 | | | | |
| | Epoxy resin 2 | | | | | | | | |
| | Cyclic imide compound | | | | | 100.0 | 100.0 | | |
| | Cyanate ester compound | | | | | | | 80.0 | |
| | Cyclopentadiene compound | | | | | | | | 100.0 |
| | Phenol resin 1 | 35.0 | 35.0 | 35.0 | 35.0 | | | | |
| | Phenol resin 2 | | | | | | | 20.0 | |
| | Curing accelerator | | | | | | | | |
| | Polymerization initiator | | | | | 2.0 | 2.0 | | 1.0 |
| (B) | LDS additive 1 | | 50.0 | | | | | | |
| | LDS additive 2 | | | | | | | | |
| | LDS additive 3 | 50.0 | | 50.0 | 50.0 | 25.0 | 25.0 | 50.0 | 20.0 |
| (C) | Silica particles 1 | 600.0 | 600.0 | 600.0 | 600.0 | 250.0 | 250.0 | 500.0 | 180.0 |
| | Alumina particles 1 | | | | | | | | |
| (D) | Triazine functional group silane coupling agent | | | | | | | | |
| | Isocyanate functional group silane coupling agent | | | | | | | | |
| | Isocyanuric acid functional group silane coupling agent | | | | | | | | |
| | Benzotriazole functional group silane coupling agent | | | | | | | | |
| | Acid anhydride functional group silane coupling agent | | | | | | | | |
| | Azasilacyclopentane functional group silane coupling agent | | | | | | | | |
| | Imidazole functional group silane coupling agent | | | | | | | | |
| | Mercapto functional group silane coupling agent | 3.0 | | | | 3.0 | | | 3.0 |
| | Amino functional group silane coupling agent | | 3.0 | 3.0 | | | | | |
| | Epoxy functional group silane coupling agent | | | | 3.0 | | 3.0 | 3.0 | 3.0 |
| | Release agent | 1.0 | 1.0 | 1.0 | 1.0 | 1.0 | | 1.0 | 1.0 |
| | Colorant | | 0. 5 | | | | | | |
| Evaluati on results | Hexavalent chromium content in LDS additive (ppm) | 263 | 88 | 263 | 263 | 263 | 263 | 263 | 263 |
| | Plating wiring resistance (Ω) | <1 | <1 | <1 | <1 | <1 | <1 | <1 | <1 |
| | Presence or absence of short circuit between wirings | Absent | Absent | Absent | Absent | Absent | Absent | Absent | Absent |
| | Adhesiveness evaluation (number of peeled platings (out of 10)) | 5 | 5 | 3 | 3 | 10 | 10 | 2 | 8 |
| | Temperature cycle test (presence or absence of cracks) | Present | Present | Absent | Present | Absent | Absent | Present | Present |
| | Internal plating property | Excellen t | Excellen t | Excellen t | Excellen t | Excellen t | Excellen t | Excellen t | Excellent |

The cured materials of the inventive thermosetting resin compositions contained certain coupling agents (D). Therefore, the cured materials were excellent in continuity of the plating wiring, there were no short circuits between wirings (excellent in surface plating property), the platings were not peeled off (excellent in adhesiveness between the plating layer and the cured material), cracks did not occur in the semiconductor devices in the temperature cycle test, and the plating property inside the through-holes were also excellent. As described, with a component (D) that has certain functional groups, the bond between the LDS additive and the thermosetting resin becomes strong. In addition, an alkoxy group bonded to a silicon atom also bonds to the surface of a blended inorganic filler. Therefore, the plating metal layer forms a strong bond with the cured material, and is not easily detached. In particular, adhesiveness between the plating layer and the cured material is excellent even when the LDS additive is surface-treated, so that cracks due to mechanical stress and thermal stress do not occur (Example 4). Accordingly, the choice for LDS additives that can be adopted becomes wider. On the other hand, in Comparative Examples 1 to 8, where a composition containing a coupling agent different from those of the component (D) was cured, the adhesiveness between the plating layer and the cured material was poor. Moreover, a crack appeared in the semiconductor device in the temperature cycle test in some cases (Comparative Examples 1, 2, 4, 7, and 8), and adhesiveness and resistance to cracks were not compatible.

As obvious from the above results, the inventive composition is able to form a metal layer excellent in adhesiveness by electroless plating of a surface of a cured material, and is able to also achieve resistance to cracks at the same time. Therefore, the inventive composition is suitable for communication devices that require electromagnetic shielding property, semiconductor devices equipped with antennas, and semiconductor devices on which a wiring layer needs to be formed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A thermosetting resin composition, comprising:
(A) a thermosetting resin;
(B) a laser direct structuring additive;
(C) an inorganic filler; and
(D) a coupling agent,
wherein (D) the coupling agent contains one or more selected from the group consisting of a triazine functional group silane coupling agent, an isocyanate functional group silane coupling agent, an isocyanuric acid functional group silane coupling agent, a benzotriazole functional group silane coupling agent, an acid anhydride functional group silane coupling agent, an azasilacyclopentane functional group silane coupling agent, an imidazole functional group silane coupling agent, and an unsaturated group-containing silane coupling agent, and (D) the coupling agent is not a mercaptosilane coupling agent, an amino silane coupling agent, or an epoxy silane coupling agent.

2. The thermosetting resin composition according to claim 1, wherein the component (B) is a metallic oxide which is represented by an average composition formula of the following formula (1) and which has a spinel structure,
AB₂O₄ (1)
wherein "A" is one or more metallic elements selected from iron, copper, nickel, cobalt, zinc, magnesium, and manganese and B is iron, chromium, or tungsten, wherein "A" and B are not both iron at the same time.

3. The thermosetting resin composition according to claim 1 or claim 2, wherein a hexavalent chromium content in the component (B) is less than 100 ppm.

4. The thermosetting resin composition according to any one of claims 1 to 3, wherein the component (B) is a laser direct structuring additive that is not surface-treated.

5. The thermosetting resin composition according to any one of claims 1 to 4, wherein (A) the thermosetting resin contains epoxy resin.

6. The thermosetting resin composition according to any one of claims 1 to 5, wherein (A) the thermosetting resin contains a cyclic imide compound containing, in one molecule thereof, one or more dimer acid skeletons, one or more linear alkylene groups having 6 or more carbon atoms, and two or more cyclic imide groups.

7. The thermosetting resin composition according to any one of claims 1 to 6, wherein (A) the thermosetting resin contains a cyanate ester compound having two or more cyanato groups in one molecule thereof.

8. The thermosetting resin composition according to any one of claims 1 to 7, wherein (A) the thermosetting resin contains a cyclopentadiene compound represented by the following formula (2) and/or an oligomer thereof, 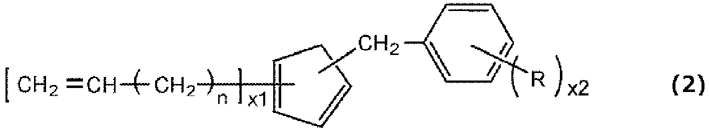 wherein in the formula (2), R represents a group selected from an alkyl group having 1 to 6 carbon atoms, an alkenyl group having 2 to 6 carbon atoms, and an aryl group having 6 to 10 carbon atoms, "n" is an integer of 1 to 4, and x1 and x2 are independently 0, 1, or 2, wherein when R represents an alkyl group or an aryl group, x1 is 1 or 2, and 1 ≤ x1 + x2 ≤ 4.

9. A cured material of the thermosetting resin composition according to any one of claims 1 to 8.

10. A semiconductor device, having the cured material according to claim 9.

11. The semiconductor device according to claim 10, wherein a part or all of the cured material is plated.

12. A method for manufacturing the semiconductor device according to claim 11, comprising:
plating a part or all of the cured material,
wherein the plating is performed on a laser-irradiated portion.
